# EUROPÄISCHE PATENTANMELDUNG

(11) **EP 4 475 633 A1**
(43) Veröffentlichungstag der Anmeldung: **11.12.2024**
(21) Anmeldenummer: 23177764.0
(22) Anmeldetag: 06.06.2023
(51) Int. Cl.: H05K 1/05, H05K 1/16, H05K 3/32, H01R 12/51, H05K 3/30, H05K 3/12, H05K 3/28

(54) **PLATTE MIT INTEGRIERTER ELEKTRISCHER FUNKTIONALITÄT UND DARAN ANGEBRACHTER ELEKTRISCHER ANSCHLUSS**

(71) Anmelder: voestalpine Stahl GmbH, 4020 Linz (AT)
(72) Erfinder: SELL, Johannes, 4020 Linz (AT); MAYRHOFER, Gerhard, 4020 Linz (AT)
(74) Vertreter: Lambsdorff & Lange Patentanwälte Partnerschaft mbB

(57) **Zusammenfassung**

Eine Platte 100 mit integrierter elektrischer Funktionalität und an der Platte angebrachter elektrischer Anschluss 400 wird beschrieben. Die Platte 100 umfasst eine Metallplatine 110, wenigstens eine Isolationsschicht 120, die über einer Hauptoberfläche der Metallplatine angeordnet ist, und eine elektrische Funktionsschicht, die über der Isolationsschicht angeordnet ist. Die elektrische Funktionsschicht weist wenigstens eine elektrische Leiterbahn sowie eine Kontaktstelle 144 zur elektrischen Kontaktierung der elektrischen Leiterbahn von dem elektrischen Anschluss 400 auf. Der elektrische Anschluss umfasst ein Metallpad 320, das mittels eines elektrischen Leitklebers 340 elektrisch leitend mit der Kontaktstelle verbunden ist, ein mit dem Metallpad verbundenes Anschlusselement 350, welches zur Kopplung des elektrischen Anschlusses an eine externe elektrische Leitung ausgelegt ist, und einen Klebstoffbereich 360, der sich seitlich benachbart dem elektrischen Leitkleber 340 befindet und den elektrischen Anschluss an der Platte fixiert.

## Beschreibung

Die Erfindung betrifft eine Platte mit integrierter elektrischer Funktionalität und einen an der Platte angebrachten elektrischen Anschluss.

Es ist bereits bekannt, Metallplatinen, d.h. zugeschnittene Metallbleche, mit einer elektrischen Funktionalität zu versehen. Damit ist es möglich, eine Direktintegration von Funktionen wie beispielsweise Sensorik, Heizung oder Zustandsüberwachung (z.B. hinsichtlich Dehnung, Zerstörung, usw.) direkt im Metallbauteil vorzunehmen. Beispielsweise sind unter der Bezeichnung tfs (tailormade functional steel) derartige Metallbauteile am Markt erhältlich.

Für die elektrische Kontaktierung derartiger Bauteile gibt es - insbesondere bei Leistungsanwendungen - bisher keine zufriedenstellende Lösung. Standard-Kontaktierungsprozesse, wie sie beispielsweise aus der Leiterplattenindustrie bekannt sind, sind aus vielerlei Gründen nicht geeignet. Beispielsweise ist eine Integration von Lötprozessen in bestehende Produktionslinien von Kunden nur mit einem hohen Zusatzaufwand möglich und erfordert Personal mit spezieller Ausbildung und Erfahrung. Andere Kontaktierungsverfahren wie Crimpen oder Kantenstecker sind bei gedruckten Leiterbahnen nicht anwendbar, invariabel in ihrer Positionierung oder für Leistungsanwendungen nicht geeignet.

Eine der Erfindung zugrundeliegende Aufgabenstellung kann daher darin gesehen werden, eine Platte, die eine Metallplatine als Träger und eine elektrische Funktionsschicht mit wenigstens einer elektrischen Leiterbahn sowie einer Kontaktstelle aufweist, mit einem zuverlässigen und einfachen elektrischen Anschluss auszustatten. Dabei sollen eine einfache Montage des elektrischen Anschlusses sowie niedrige Gestehungs- und Montagekosten der Kontaktierung ermöglicht werden. Ferner zielt die Erfindung darauf ab, ein Verfahren zum elektrischen Kontaktieren einer solchen Platte anzugeben, welches eine einfache und für die Prozesse beim Kunden geeignete Montage des Anschlusses an die elektrische Funktionsschicht der Platte ermöglicht.

Die der Erfindung zugrundeliegende Aufgabenstellung wird durch die Merkmale der unabhängigen Ansprüche gelöst. Ausführungsbeispiele und Weiterbildungen sind Gegenstand der abhängigen Ansprüche.

Demnach umfasst eine mit integrierter elektrischer Funktionalität ausgestattete Platte eine Metallplatine sowie wenigstens eine Isolationsschicht, die über einer Hauptoberfläche der Metallplatine angeordnet ist. Über der Isolationsschicht ist eine elektrische Funktionsschicht angeordnet, die wenigstens eine elektrische Leiterbahn sowie eine Kontaktstelle zur elektrischen Kontaktierung der elektrischen Leiterbahn von dem elektrischen Anschluss aufweist. Der elektrische Anschluss umfasst ein Metallpad, das mittels eines elektrischen Leitklebers elektrisch leitend mit der Kontaktstelle verbunden ist. Ferner umfasst der elektrische Anschluss ein mit dem Metallpad verbundenes Anschlusselement, welches zur Kopplung des elektrischen Anschlusses mit einer externen elektrische Leitung ausgelegt ist, sowie einen Klebstoffbereich, der sich seitlich benachbart dem elektrischen Leitkleber befindet und den elektrischen Anschluss an der Platte während der Montage vorfixiert.

Der Klebstoffbereich ermöglicht z.B. für einen Kunden einen einfachen Anbringungsprozess des Anschlusses an die Platte. Unabhängig davon, wann oder wie schnell sich die elektrische Kontaktverklebung mittels des elektrischen Leitklebers nach dem Anhaften des Anschlusses an die Platte ausbildet, ist die Platte sofort für nachfolgenden Handhabungen (beispielsweise Wenden, Lagerung, Transport, usw.) bereit, ohne dass die Gefahr eines Verrutschens oder Ablösens des Anschlusses besteht. Ferner schützt der Anschluss bei allen nachfolgenden Handhabungs- und/oder Prozessschritten die Kontaktstelle und den gegebenenfalls noch nicht gehärteten elektrischen Leitkleber. Ein mit einem Klebstoffbereich neben dem elektrischen Leitkleber versehener elektrischer Anschluss ist einfach herstellbar und in seiner Anschaffung kostengünstig.

Beispielsweise kann der elektrische Anschluss ferner eine Trägerfolie aus einem isolierenden Material aufweisen, die das Metallpad trägt und eine Öffnung aufweist, in welcher das Metallpad von dem elektrischen Leitkleber kontaktiert wird. Der Klebstoffbereich ist zwischen der Trägerfolie und der Platte angeordnet. Die Trägerfolie erleichtert das Fixieren des elektrischen Anschlusses an der Platte.

Vorzugsweise weist die Trägerfolie zumindest ein Positionierungsmerkmal zur lagerichtigen Anbringung des Metallpads auf die Kontaktstelle auf. Das Positionierungsmerkmal gestattet es, den Anschluss beispielsweise mit der Hand schnell und exakt am richtigen Ort über der Kontaktstelle zu positionieren.

Für einen sicheren Halt und einen guten Schutz vor Umgebungseinflüssen (z.B. Feuchtigkeit) kann der Klebstoffbereich den elektrischen Leitkleber seitlich von allen Seiten umgeben.

Vorzugsweise wird als Klebstoff des Klebstoffbereichs ein Haftklebstoff eingesetzt. Dadurch ist der Anschluss selbstklebend, wobei die Haftung des Anschlusses an der Platte durch einen Anpressdruck erreicht wird. Durch das Anpressen vergleichmäßigt sich außerdem der Leitkleber.

Bei dem elektrischen Leitkleber kann es sich beispielsweise um einen Leitkleber auf Silberbasis oder auf Kupferbasis handeln.

Die elektrisch leitende Leitkleberverbindung kann zu einem späteren Zeitpunkt (z.B. nach der Durchhärtung eines 2-komponentigen (2K) Klebers oder in einem nachfolgenden thermischen Prozess zur Aushärtung des z.B. 1-komponentigen (1K) Klebers) gebildet werden.

Die elektrische Funktionsschicht der Platte kann insbesondere eine elektrische Leistungseinrichtung umfassen, beispielsweise eine Widerstandsheizung und/oder eine Strom-Leistungsverbindung (d.h. eine sogenannte "Connect-Anwendung" im Leistungsbereich) realisieren. Bei elektrischen Leistungseinrichtungen müssen hohe Ströme über elektrische Leiterbahnen übertragen werden und/oder hohe Spannungen (beispielsweise Netzspannungen von z.B. 110 V oder 230 V) angelegt werden. Hierfür werden vergleichsweise großflächige Kontaktstellen benötigt, für die der hier offenbarte elektrische Anschluss besonders gut geeignet ist. Beispielsweise können bei Leistungsanwendungen gleich oder mehr als 200W, 400W, 600W 800W, 1000W, 1200W, 1400W, 1600W oder mehr Leistung umsetzen und/oder Ströme gleich oder größer als 2A, 5A, 10A, 15A, 20A oder mehr transportieren. Die an die Anschlüsse anlegbaren Gleich- oder Wechselspannungen können bei Leistungsanwendungen z.B. gleich oder größer als 10V, 30V, 60V, 100V, 200V oder 250V sein.

Die elektrische Leiterbahn und die Kontaktstelle können mittels einer elektrisch leitfähigen Tinte als gedruckte Strukturen realisiert sein. Kontaktstellen aus elektrisch leitfähigen Tinten lassen sich über den elektrischen Leitkleber - auch für die Übertragung hoher Ströme - gut kontaktieren, wobei andererseits Standard-Kontaktierungsverfahren, wie beispielsweise Löten, nicht oder nur mit hohem Aufwand für gedruckte Leiterbahnen über einer Metallplatine anwendbar wären.

Über der elektrischen Funktionsschicht kann beispielsweise eine Decklackschicht angeordnet sein, die an der Kontaktstelle eine Aussparung aufweist. Ferner ist es möglich, über der elektrischen Funktionsschicht und optional über dem Metallpad eine Beschichtung vorzusehen, bei der es sich beispielsweise um eine Pulverbeschichtung handeln kann. Mit beiden Maßnahmen (Decklackschicht und/oder Pulverbeschichtung) kann eine finale, isolierende Abdeckung der elektrischen Funktionsschicht, gegebenenfalls unter Einbeziehung des Anschlussbereichs (Pulverbeschichtung), realisiert werden.

Ein Verfahren zum elektrischen Kontaktieren einer Platte mit integrierter elektrischer Funktionalität umfasst das Bereitstellen der Platte, die eine Metallplatine, wenigstens eine Isolationsschicht, die über einer Hauptoberfläche der Metallplatine angeordnet ist, und eine elektrische Funktionsschicht aufweist. Dabei ist die elektrische Funktionsschicht über der Isolationsschicht angeordnet und weist wenigstens eine elektrische Leiterbahn sowie eine Kontaktstelle zur elektrischen Kontaktierung der elektrischen Leiterbahn von einem elektrischen Anschluss auf. Auf die Kontaktstelle wird ein elektrischer Leitkleber aufgetragen. Der elektrische Anschluss wird an der Platte über dem elektrischen Leitkleber fixiert, wobei der elektrische Anschluss ein Metallpad, das mittels des elektrischen Leitklebers elektrisch leitend mit der Kontaktstelle verbindbar ist, ein mit dem Metallpad verbundenes Anschlusselement, welches zur Kopplung des elektrischen Anschlusses an eine externe elektrische Leitung ausgelegt ist, und einen Klebstoffbereich aufweist, der sich seitlich benachbart dem elektrischen Leitkleber befindet und den elektrischen Anschluss an der Platte fixiert. Anschließend oder zu einem späteren Zeitpunkt erfolgt ein Aushärten des elektrischen Leitklebers, wodurch sich die finale elektrische Verbindung zwischen der Kontaktstelle und dem Metallpad ausbildet.

Beispielsweise können zur Bereitstellung der Platte ein Metallband oder Metallblech, zur Erzeugung der wenigstens einer Isolationsschicht, ein- oder mehrfach lackiert werden. Das Metallband oder Metallblech kann anschließend in einzelne Metallplatinen geschnitten werden. Das Erzeugen der elektrischen Funktionsschicht kann unter Verwendung eines Druckprozesses, insbesondere Siebdruck, zum Bilden der Leiterbahn und der Kontaktstelle aus elektrisch leitfähiger Tinte erfolgen. Auf diese Weise lassen sich kostengünstig Platten mit integrierter elektrischer Funktionsschicht herstellen.

Das Auftragen des elektrischen Leitklebers auf die Kontaktstelle kann mittels einer Schablone erfolgen. Auf diese Weise lässt sich der elektrische Leitkleber lagegenau und durch die Schablone exakt in seinen Ausmaßen begrenzt auf die Kontaktstelle auftragen. Dadurch kann auch erreicht werden, dass beim Fixieren des elektrischen Anschlusses kein elektrischer Leitkleber zwischen den Klebstoffbereich und die Platte gelangen kann.

Das Fixieren des elektrischen Anschlusses kann vorzugsweise ein Abziehen einer den Klebstoffbereich abdeckenden Transferfolie sowie das Anpressen des elektrischen Anschlusses mit dem freigelegten Klebstoffbereich an die Platte umfassen. Durch die Transferfolie werden der Klebstoffbereich und gegebenenfalls auch die Kontaktfläche des Metallpads geschützt und eine einfache Lagerung und Handhabung des elektrischen Anschlusses ermöglicht.

Nach dem Fixieren des elektrischen Anschlusses und vor dem Aushärten des elektrischen Leitklebers können weitere Handhabungsprozesse, wie beispielsweise Wenden und/oder Stapeln und/oder Transportieren an der Platte vorgenommen werden, ohne dass der elektrische Anschluss dabei verrutscht oder sich ablöst. D.h., der Anschluss wird durch das Anhaften des Klebstoffbereichs an der Platte vorfixiert, während eine endgültige mechanisch hochstabile Verbindung zwischen Anschluss und Platte (optional) erst durch das Aushärten des elektrischen Leitklebers erreicht wird. Dazwischen können ein oder mehrere Stunden, Tage oder z.B. etwa bis zu ein oder mehreren (z.B. zwei oder drei) Wochen liegen.

Ferner kann das Verfahren ein Beschichten, insbesondere Pulverbeschichten der Platte umfassen. Falls das Aushärten des elektrischen Leitklebers eine Anwendung von Wärme umfasst, kann diese Wärmeanwendung beim Beschichten erfolgen. Das heißt, wenn der verwendete elektrische Leitkleber einen Wärmeaushärtungsschritt erfordert, kann dieser im Rahmen z.B. der Pulverbeschichtung (die ebenfalls eine Wärmeanwendung benötigt) kostenoptimiert realisiert werden.

Beispiele und Ausführungsmöglichkeiten der Erfindung werden nachfolgend unter Bezugnahme auf die Zeichnungen näher erläutert. Die Elemente in den Zeichnungen sind nicht unbedingt maßstabsgetreu zueinander. Gleiche Bezugszeichen bezeichnen einander entsprechende oder ähnliche Teile. Die Merkmale der verschiedenen dargestellten Ausführungsbeispiele können selektiv kombiniert werden, sofern sie sich nicht gegenseitig ausschließen, und/oder sie können selektiv weggelassen werden, wenn sie nicht als unbedingt erforderlich beschrieben werden.
Figur 1 zeigt eine schematische Ansicht einer beispielhaften Platte mit integrierter elektrischer Funktionalität in perspektivischer Draufsicht.
Figur 2 zeigt die Platte der Figur 1 mit einer über der elektrischen Funktionsschicht angeordneten Decklackschicht in perspektivischer Draufsicht.
Figur 3 zeigt eine schematische Teilschnittansicht eines Beispiels eines elektrischen Anschlusses an einer Platte mit integrierter elektrischer Funktionsschicht.
Figur 4 zeigt eine schematische Teilschnittansicht eines weiteren Beispiels eines elektrischen Anschlusses an einer Platte mit integrierter elektrischer Funktionsschicht.
Figur 5 zeigt ein Beispiel eines elektrischen Anschlusses in perspektivischer Draufsicht.
Figur 6 zeigt eine schematische Draufsicht auf die Unterseite eines Beispiels eines elektrischen Anschlusses.
Figur 7 zeigt eine schematische Schnittansicht eines Beispiels eines Anschlusses mit daran angebrachter Transferfolie.
Figur 8 zeigt eine schematische Teilschnittansicht eines Beispiels eines elektrischen Anschlusses an einer Platte mit integrierter elektrischer Funktionsschicht und Beschichtung.
Figur 9 zeigt ein Ablaufdiagramm, welches beispielhaft ein Verfahren zum elektrischen Kontaktieren einer Platte mit integrierter elektrischer Funktionalität darstellt.

Die Begriffe "elektrisch verbunden" oder "elektrisch gekoppelt" oder ähnliche Begriffe sind nicht so zu verstehen, dass die Elemente direkt miteinander in Kontakt stehen; zwischen den "elektrisch verbundenen" bzw. "elektrisch gekoppelten" Elementen können Zwischenelemente vorgesehen sein. Gemäß der Offenbarung können die oben genannten und ähnlichen Begriffe jedoch optional auch die spezifische Bedeutung haben, dass die Elemente direkt miteinander kontaktiert sind, d.h. dass keine Zwischenelemente zwischen den "elektrisch verbundenen" bzw. "elektrisch gekoppelten" Elementen vorgesehen sind.

Ferner können die Begriffe "über" oder "unter" in Bezug auf ein Teil, ein Element oder eine Materialschicht, das/die "über" oder "unter" einer Oberfläche geformt oder lokalisiert oder angeordnet ist, hier verwendet werden, um zu bedeuten, dass das Teil, das Element oder die Materialschicht "direkt auf" oder "direkt unter", d.h. in direktem Kontakt mit der angesprochenen Oberfläche, lokalisiert (z.B. platziert, geformt, angeordnet, abgelagert usw.) ist. Der Begriff "über" oder "unter", der in Bezug auf ein Teil, ein Element oder eine Materialschicht verwendet wird, das/die "über" oder "unter" einer Oberfläche geformt oder lokalisiert ist, kann hier jedoch auch so verwendet werden, dass das Teil, das Element oder die Materialschicht "indirekt auf" oder "indirekt unter" der angesprochenen Oberfläche lokalisiert (z.B. platziert, geformt, angeordnet, abgelagert usw.) ist, wobei ein oder mehrere zusätzliche Teile, Elemente oder Schichten zwischen der angesprochenen Oberfläche und dem Teil, dem Element oder der Materialschicht angeordnet sind.

Im Folgenden werden auf einem Metallträger (Metallplatine) basierende Produkte (Platten) beschrieben, die durch die Integration einer elektrischen Funktionsschicht einen zusätzlichen Nutzen oder eine zusätzliche Anwendung zu konventionellen Metallplatinen bieten.

Der zusätzliche Nutzen oder die zusätzliche Anwendung können in verschiedensten technischen Bereichen liegen. Beispielsweise können elektrische Bauelemente (z.B. LEDs, Sensoren, usw.) in die Platte eingebaut oder auf die Platte aufgebracht werden, die über die Leiterbahnen mit Strom versorgt werden und/oder für die die Leiterbahnen Signalleitungen bilden.

Beispielsweise kann die elektrische Funktionsschicht eine Sensorik umfassen. Beispielsweise kann eine Sensorik in die Platte eingebaut oder auf die Platte aufgebracht sein, die z.B. für Schließfachsysteme den Beladungszustand der Platte erkennt.

Die zusätzliche Funktionalität kann beispielsweise auch allein die Übertragung/Verteilung von Strömen oder Signalen (sogenannte "Connect-Anwendungen") im Niederleistungsbereich oder im Leistungsbereich umfassen.

Weitere Anwendungen betreffen beispielsweise die Zustandsüberwachung ("condition monitoring"), bei welcher der Zustand der Metallplatine oder eines mit der Metallplatine in Kontakt stehenden Körpers überwacht wird. Beispiele hierfür sind die Überwachung der Dehnung oder der strukturellen Unversehrtheit der Metallplatine, indem die elektrische Funktionsschicht beispielsweise mit einem oder mehreren Dehnungsmessstreifen und/oder Unterbrechungsmessstreifen versehen ist. Hierdurch können kritische Belastungssituationen oder beispielsweise Rissbildung, Zerstörung, Vandalismus oder Einbruchsgeschehen erfasst werden.

Im Leistungsbereich kann die zusätzliche Funktionalität beispielsweise eine Heizung oder auch die genannten "Connect-Anwendungen" (Übertragung/Verteilung von hohen Strömen) umfassen (wobei die Ströme nicht durch die Metallplatine, sondern die elektrische Funktionsschicht übertragen oder verteilt werden).

Generell ermöglicht die Integration einer elektrischen Funktionalität direkt in die Platte ein "intelligentes" Bauteil, wodurch zusätzliche elektrische Komponenten, die andernfalls separat an- oder eingebaut würden müssten, entfallen können. Derartige Bauteile sind auch unter der Bezeichnung tfs (tailormade functional steel) für Stahlplatinen bekannt.

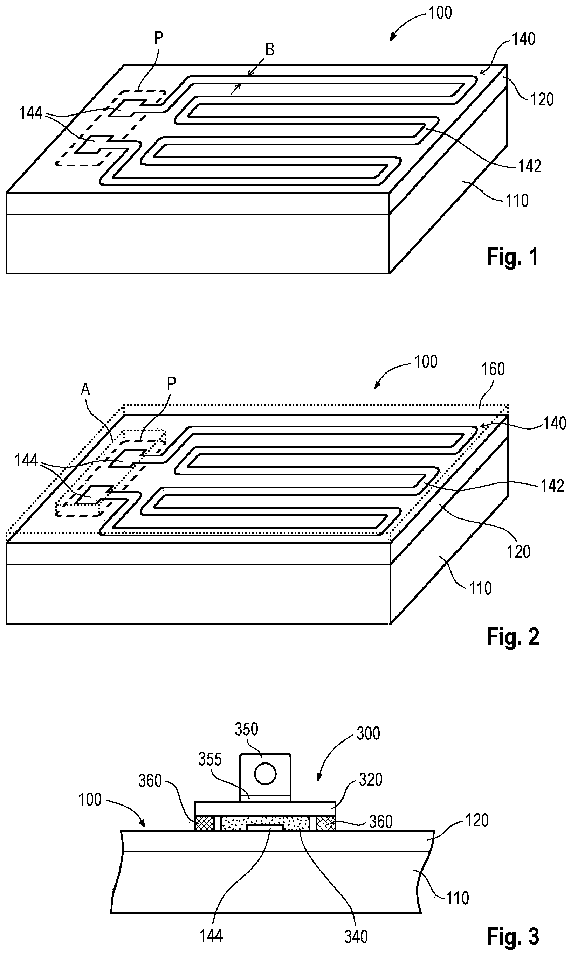

Figur 1 zeigt ein Beispiel einer Platte 100. Die Platte 100 weist eine Metallplatine 110 auf, welche aus einem zugeschnittenen Metallblech oder Metallband gebildet ist.

Die Metallplatine 110 (ebenso die Platte 100) kann seitliche Abmessungen von beispielsweise gleich oder größer oder kleiner als 0,2 m, 0,5 m, 0,75 m, 1 m oder 2 m aufweisen. Die Metallplatine 110 kann plan sein oder bei einem fertiggestellten Bauteil gekrümmt oder entlang einer oder mehreren Linien gebogen oder umgeformt sein. Die Metallplatine 110 (ebenso die Platte 100) kann durchgängig, d.h. ohne Öffnungen ausgeführt sein. Es ist jedoch auch möglich, dass die Metallplatine 110 (und damit auch die Platte 100) Freibereiche, Öffnungen oder Einschnitte und dergleichen aufweist. Beispielsweise kann die Metallplatine 110 (ebenso die Platte 100) auch in Form eines Gitters realisiert sein.

Beispielsweise kann die Metallplatine 110 eine Platine aus Stahl oder Aluminium oder Magnesium oder Kupfer oder einer oder mehreren Legierungen basierend auf den genannten Materialien sein, wobei ferner eine oder mehrere metallische Schutzschichten (wie beispielsweise eine Zink-Antikorrosionsschicht) vorhanden sein können. Insbesondere kann die Metallplatine 110 eine verzinkte Stahlplatine sein.

Über einer ersten Hauptoberfläche der Metallplatine 110 ist wenigstens eine elektrische Isolationsschicht 120 angeordnet. Die elektrische Isolationsschicht 120 kann beispielsweise eine ein- oder mehrlagige Lackschicht sein, die auf ein Ausgangsmaterial (z.B. Metallband oder Metallblech) aufgetragen wird oder nach dem Zuschnitt auf die Metallplatine 110 aufgebracht wird.

Die Isolationsschicht 120 kann eine oder mehrere Lackschichtlagen, beispielsweise auf Polyester- und/oder Polyurethanbasis, umfassen.

Über der Isolationsschicht 120 ist eine elektrische Funktionsschicht 140 angeordnet. Die elektrische Funktionsschicht 140 dient der Bereitstellung der Funktionalität der Platte 100. Die elektrische Funktionsschicht 140 enthält wenigstens eine elektrische Leiterbahn 142 sowie wenigstens eine Kontaktstelle 144 zur elektrischen Kontaktierung der elektrischen Leiterbahn 142.

Die Geometrie der elektrischen Leiterbahn 142 kann je nach Anwendung sehr unterschiedlich sein. Für eine Heizungsanwendung (oder z.B. auch für eine magnetische Anwendung unter Verwendung einer Spule) kann die elektrische Leiterbahn 142 beispielsweise einen mäanderförmigen oder gewundenen Verlauf zeigen. Ferner sind Verzweigungen der Leiterbahn(en) 142 zur Verteilung eines Stromflusses über die Platte 100 z.B. für Dehnungsmessstreifen oder dergleichen möglich.

Bei der in Figur 1 beispielhaft dargestellten Funktionsschicht 140 kann es sich um eine Heizungsanwendung handeln, wobei die elektrische Leiterbahn 142 mehrere Heizwendel umfasst.

Insbesondere kann sich die elektrische Leiterbahn 142 großflächig über die Metallplatine 110 erstrecken. Beispielsweise kann sich die elektrische Leiterbahn 142 in einer und/oder beiden seitlichen Plattendimensionen über mindestens 50% oder 80% des Maßes der Metallplatine 110 erstrecken. Es ist auch möglich, dass die Leiterbahn 142 von einem Randbereich der Metallplatine 110 zu einem gegenüberliegenden Randbereich der Metallplatine 110 verläuft und/oder ein oder mehrere solcher Leiterbahnen 142 sich über im Wesentlichen die gesamte Fläche der Metallplatine 110 verteilen.

Die Leiterbahn 142 kann beispielsweise eine Breite B von gleich oder größer oder kleiner als 0,5 cm, 1 cm, 2 cm, 4 cm oder 10 cm aufweisen. Noch größere Leiterbahnbreiten bis hin zu einer die Metallplatine 110 im Wesentlichen ganzflächig (z.B. über 80%, 90% und bis zu 100% der Metallplatine) bedeckenden Leiterbahn 142 sind realisierbar.

Die Kontaktstelle 144 zur elektrischen Kontaktierung der elektrischen Leiterbahn 142 kann an beliebigen Positionen der Leiterbahn 142 vorgesehen sein. Es können mehrere Kontaktstellen 144 vorhanden sein, wodurch der oder die elektrischen Anschlüsse wahlweise an unterschiedlichen Orten positioniert werden können. Es ist auch möglich, dass beliebige Abschnitte der Leiterbahn 142 als Kontaktstelle(n) 144 benutzt werden können. Wie in Figur 1 gezeigt können beispielsweise zwei oder mehr Kontaktstellen 144 an den Enden der elektrischen Leiterbahn 142 vorhanden sein.

Figur 1 zeigt in beispielhafter Darstellung die Setzposition P eines elektrischen Anschlusses, der an der Platte 100 angebracht werden soll, um die elektrische Funktionsschicht 140 an der oder den Kontaktstellen 144 elektrisch zu kontaktieren.

Wie im Folgenden noch näher erläutert wird, kann es sich bei der elektrischen Leiterbahn 142 sowie bei der Kontaktstelle 144 um Strukturen handeln, die aus einer elektrisch leitfähigen Tinte gebildet sind. Derartige Strukturen lassen sich durch ein Druckverfahren (beispielsweise Siebdruck) erzeugen. Dabei können elektrisch leitfähige Tinten eingesetzt werden, die Metallpartikel enthalten, welche nach der Trocknung der Tinte elektrisch leitfähige Strukturen schaffen. Beispielsweise kann eine elektrisch leitfähige Tinte mit Silberpartikeln und/oder eine elektrisch leitfähige Tinte mit Kupferpartikeln verwendet werden.

Figur 2 zeigt die Platte 100 mit einer über der elektrischen Funktionsschicht 140 angeordneten Decklackschicht 160. Die transparent und durch gestrichelte Linien dargestellte (optionale) Decklackschicht 160 kann der elektrischen Isolierung der elektrischen Leiterbahn 142 dienen. Bei der Decklackschicht 160 kann es sich sowohl um eine Zwischenschicht als auch um eine finale Abdeckung der Platte 100 handeln.

Die Decklackschicht 160 weist im Bereich der Setzposition P an der oder den Kontaktstellen 144 eine Aussparung A auf. Diese Aussparung A bewirkt, dass die Kontaktstellen 144 auch nach der Anbringung der (optionalen) Decklackschicht 160 noch freiliegen.

Figur 3 zeigt beispielhaft einen an die Platte 100 angebrachten elektrischen Anschluss 300. Der elektrische Anschluss 300 kontaktiert die Kontaktstelle 144 der elektrischen Leiterbahn 142. Der elektrische Anschluss 300 umfasst ein Metallpad 320, das mittels eines elektrischen Leitklebers 340 elektrisch leitend mit der Kontaktstelle 144 verbunden ist.

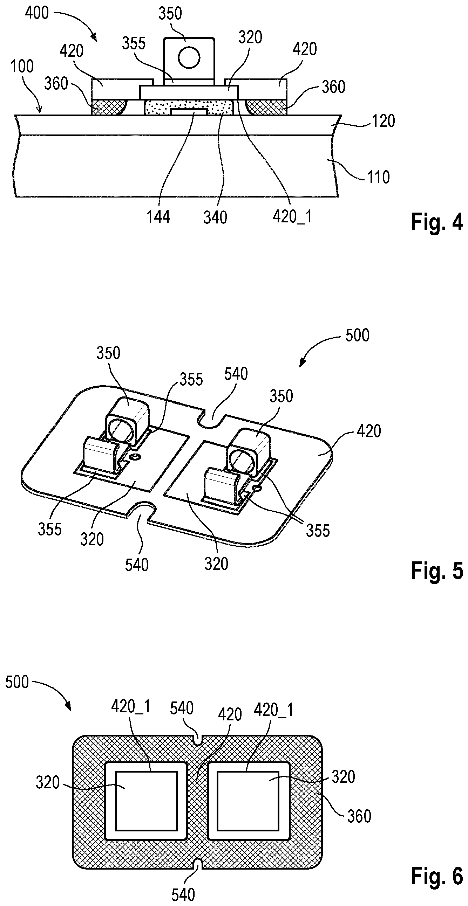

Wie im Folgenden noch näher beschrieben wird, kann das Metallpad 320 als ein Metallpad einer Leiterplatte (siehe z.B. Figur 5) sein.

Der elektrische Leitkleber 340 kann ein Ein- oder Mehrkomponentenkleber beispielsweise auf Epoxidbasis sein, der mit Metallteilchen (z.B. aus Silber oder Kupfer) gefüllt ist.

Ferner weist der elektrische Anschluss 300 ein mit dem Metallpad 320 verbundenes Anschlusselement 350 auf. Das Anschlusselement 350 dient zur Kopplung des elektrischen Anschlusses 300 an eine externe elektrische Leitung (nicht gezeigt) . Beispielsweise kann die Kopplung in Form einer direkten elektrischen Kontaktierung erfolgen. In diesem Fall kann das Anschlusselement 350 beispielsweise eine Steckerbuchse oder eine Anschlussklemme sein.

Der Anschluss 300 weist einen Klebstoffbereich 360 auf, der sich seitlich benachbart dem elektrischen Leitkleber 340 befindet. Der Klebstoffbereich 360 dient dazu, den Anschluss 300 an der Platte 100 zu fixieren (insbesondere auch schon zu einem Zeitpunkt, an dem der elektrische Leitkleber 340 noch nicht ausgehärtet ist).

Der Klebstoff des Klebstoffbereichs 360 ist ein anderer Klebstoff als der Klebstoff des elektrischen Leitklebers 340. Beispielsweise kann es sich bei dem Klebstoff des Klebstoffbereichs 360 um einen Haftklebstoff handeln. Ein Haftklebstoff ist ein permanenter Klebstoff, der bei Andrücken des Anschlusses 300 an die Platte 100 sofort haftet und den Anschluss 300 an der Platte 100 fixiert. Gegebenenfalls kann auch ein schnellklebender Kontaktklebstoff zum Einsatz kommen.

Der Klebstoffbereich 360 des Anschlusses 300 kann beispielsweise am Metallpad 320 vorgesehen sein, siehe Figur 3. In anderen Beispielen eines elektrischen Anschlusses 400 (Figur 4) kann eine Trägerfolie 420 z.B. aus einem isolierenden Material vorgesehen sein, die das Metallpad 320 trägt und z.B. eine Öffnung 420_1 aufweist, in welcher das Metallpad 320 von dem elektrischen Leitkleber 340 kontaktiert wird. Bei diesem elektrischen Anschluss 400 ist der Klebstoffbereich 360 zwischen der Trägerfolie 420 und der Platte 100 angeordnet.

Figur 5 zeigt ein Beispiel eines elektrischen Anschlusses 500, dessen Aufbau im Wesentlichen dem Aufbau des Anschlusses 400 entspricht. Das heißt, der hier beispielsweise für die Kontaktierung von zwei Kontaktstellen 144 ausgelegte Anschluss 500 weist eine Trägerfolie 420 für zwei voneinander getrennte Metallpads 320 auf. Jedes Metallpad 320 ist mit einem Anschlusselement 350 verbunden.

Bei allen elektrischen Anschlüssen kann das Anschlusselement 350 beispielsweise mittels einer Lötverbindung 355 an dem Metallpad 320 angebracht sein.

Der Klebstoffbereich 360 kann den elektrischen Leitkleber 144 von allen Seiten umgeben, wie dies beispielsweise für zwei Metallpads 320 in Figur 6 gezeigt ist. Für den elektrischen Anschluss 300, der ohne Trägerfolie 420 auskommt, kann der Klebstoffbereich 360 ebenfalls allseitig und z.B. als geschlossener Ringbereich um die elektrische Kontaktstelle 144 und den elektrischen Leitkleber 340 herumgeführt sein. Dadurch wird ein weitgehender Schutz des elektrischen Leitklebers 340 vor äußeren Einflüssen bewirkt, welcher besonders für Fälle, in denen der elektrische Leitkleber 340 erst Stunden, Tage oder Wochen nach seiner Aufbringung aktiviert (beispielsweise vernetzt) wird, die Lagerfähigkeit des elektrischen Leitklebers 340 erhöht.

Beispielsweise kann die Trägerfolie 420 eine Polyimid-Folie enthalten oder aus einer solchen bestehen. Die Trägerfolie 420 kann flexibel sein, wodurch die Anbringung des elektrischen Anschlusses 400, 500 an die Platte 100 erleichtert wird.

Der elektrische Anschluss 300, 400, 500 kann beispielsweise eine Leiterplatte umfassen. Eine (zweiseitige) Leiterplatte weist ein Basismaterial (sogenannter Leiterplattenkern) aus einem isolierenden Material (beispielsweise auf der Basis von Epoxyharz oder Polyimid) und beidseitige Metalllagen (z.B. Kupferlagen) auf, die über eine oder mehrere Durchkontaktierungen elektrisch miteinander verbunden sind. In diesem Fall ist das Kontaktpad 320 aus der der Metallplatine 110 zugewandten Metalllage der Leiterplatte strukturiert. An der gegenüberliegenden Metalllage kann das Anschlusselement 350 angebracht sein. Die Leiterplatte kann eine starre Leiterplatte oder eine flexible Leiterplatte sein.

D.h., anstelle der Trägerfolie 420 mit Öffnung und dem Metallpad 320 (siehe Figur 4) kann beispielsweise eine Leiterplatte eingesetzt werden, wobei die Trägerfolie 420 der Figuren 4 bis 6 dem Leiterplattenkern (z.B. FR4 oder Polyimid) entspricht und in diesem Fall die Bezugszeichen 320 in den Figuren 5 und 6 obere bzw. untere strukturierte Metalllagen (Metallpads) der Leiterplatte bezeichnen.

Die Trägerfolie 420 (bzw. entsprechend das Basismaterial einer Leiterplatte) kann seitlich über das Metallpad 320 überstehen. Der überstehende Bereich kann zumindest teilweise als Träger für den Klebstoffbereich 360 dienen. Der Klebstoffbereich 360 kann, wie bereits erwähnt, durch einen Haftkleber oder einen anderen durch Andrücken des elektrischen Anschlusses 300, 400, 500 an die Platte 100 schnellhaftenden Kleber realisiert sein.

Beispielsweise kann der Klebstoffbereich 360 durch eine beidseitige Klebefolie (doppelseitiges Klebeband) gebildet sein. Die den Klebstoffbereich 360 bildende beidseitige Klebefolie kann, wie in den Figuren 3 bis 6 gezeigt, das oder die Metallpads 320 beispielsweise von allen Seiten (z.B. ringförmig) umgeben. Wenn, wie in den Figuren 5 und 6 beispielhaft dargestellt, mehrere Metallpads 320 in einem elektrischen Anschluss 400, 500 zusammengefasst sind, kann sich der Klebstoffbereich 360 auch zwischen den Metallpads 320 erstrecken, um zu verhindern, dass sich der Leitkleber 340 in diesen Bereich ausbreitet (Kurzschlussgefahr) und um die Anhaftung des elektrischen Anschlusses 300, 400, 500 an der Platte 100 zu erhöhen.

Die Trägerfolie (oder Leiterplatte) 420 kann mit einem Positionierungsmerkmal 540 versehen sein, welches es ermöglicht, das oder die Metallpads 320 lagegenau auf der oder den Kontaktstellen 144 zu platzieren. Das Positionierungsmerkmal 540 ist in den Figuren 5 und 6 durch zwei seitliche Einschnitte der Trägerfolie (oder Leiterplatte) 420 veranschaulicht, es können jedoch auch andere Justier-Marken verwendet werden. Z.B. bei dem in den Figuren 5 und 6 dargestellten Beispiel können auf der Platte 100 im Bereich der Setzposition P (siehe Figur 1) des elektrischen Anschlusses 500 Setzmarkierungen (nicht gezeigt) vorhanden sein, die beim lagerichtigen Platzieren des elektrischen Anschlusses 500 mit dem Positionierungsmerkmal 540 ausgerichtet sind (d.h., beispielsweise in den seitlichen Einschnitten der Trägerfolie (oder Leiterplatte) 420 sichtbar sind).

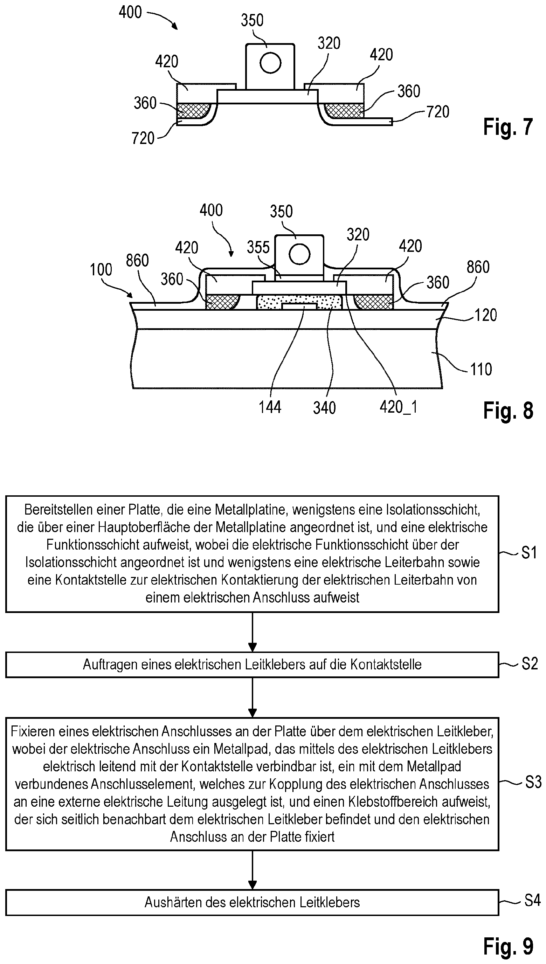

Figur 7 zeigt den elektrischen Anschluss 400 mit einer Transferfolie 720, die den Klebstoffbereich 360 (und optional auch die Anschlussfläche des Metallpads 320) abdeckt. Kurz vor dem Anbringen des elektrischen Anschlusses 400 an die Platte 100 wird die Transferfolie 720 abgezogen, um den elektrischen Anschluss 400 haftend auf der Platte 100 zu fixieren.

Ferner veranschaulicht Figur 7, dass es sich bei dem Anschlusselement 350 gegebenenfalls auch um ein integrales Teil des Kontaktpads 320 handeln kann, d.h. es ist nicht zwingend erforderlich, dass das Anschlusselement 350 beispielsweise durch eine Lötverbindung an dem Metallpad 320 angebracht ist.

Bezugnehmend auf Figur 8 kann anstelle oder zusätzlich zu der einen oder den mehreren Decklackschichten 160 nach dem Anbringen des elektrischen Anschlusses 300, 400, 500 eine Beschichtung 860 über der elektrischen Funktionsschicht 140 und gegebenenfalls über dem Metallpad 320 angeordnet sein. Die Beschichtung 860 kann, sofern vorhanden, beispielsweise auch die Trägerfolie (oder Leiterplatte) 420 überdecken. Bei der Beschichtung 860 kann es sich um die finale Beschichtung der Platte 100 handeln. Die Beschichtung 860 kann beispielsweise eine Pulverbeschichtung sein. Sie kann beispielsweise als Dekorbeschichtung ästhetische Ansprüche in Hinblick auf die Optik und/oder Haptik erfüllen.

Gemäß Figur 9 umfasst ein Verfahren zum elektrischen Kontaktieren einer Platte mit integrierter elektrischer Funktionalität bei S1 das Bereitstellen der Platte. Die Platte weist eine Metallplatine, wenigstens eine Isolationsschicht, die über einer Hauptoberfläche der Metallplatine angeordnet ist, und eine elektrische Funktionsschicht auf. Dabei ist die elektrische Funktionsschicht über der Isolationsschicht angeordnet und weist wenigstens eine elektrische Leiterbahn sowie eine Kontaktstelle zur elektrischen Kontaktierung der elektrischen Leiterbahn von einem elektrischen Anschluss auf.

Das Bereitstellen der Platte kann ein einfaches oder mehrfaches Lackieren eines Metallbands oder Metallblechs zur Erzeugung der wenigstens einen Isolationsschicht umfassen. Ferner kann das Bereitstellen der Platte das Schneiden des Metallbands oder Metallblechs in einzelne Metallplatinen enthalten.

Das Erzeugen der elektrischen Funktionsschicht kann, wie bereits beschrieben, beispielsweise einen Druckprozess, insbesondere Siebdruck, zum Bilden der Leiterbahn und der Kontaktstelle enthalten. Die elektrische Funktionsschicht kann entweder auf den einzelnen Metallplatinen oder vor dem Zuschnitt auf dem Metallband oder Metallblech erzeugt werden.

Bei S2 wird ein elektrischer Leitkleber auf die Kontaktstelle aufgetragen.

Das Auftragen des elektrischen Leitklebers kann mittels einer Schablone vorgenommen werden, welche zumindest eine Öffnung aufweist, die über die wenigstes eine Kontaktstelle der Leiterbahn positioniert wird. Danach wird der elektrische Leitkleber durch die Öffnung der Schablone auf die Kontaktstelle aufgebracht und überschüssiger Leitkleber beispielsweise einfach mit einem Spachtel abgezogen. Dadurch kann ein Leitkleberdepot mit exakt vorgegebenen Ausmaßen (in Bezug auf Länge, Breite und Höhe), d.h. mit einem exakt vorgegebenen Volumen auf die Kontaktstelle appliziert werden. Danach wird die Schablone entfernt.

Gemäß einem anderen Beispiel wird der elektrische Leitkleber mittels einer Dosiervorrichtung (z.B. Dispenser) auf die Kontaktstelle aufgetragen.

Anschließend wird der elektrische Anschluss an der Platte über dem elektrischen Leitkleber fixiert, siehe S3. Gegebenenfalls wird zuvor eine den Klebstoffbereich abdeckende Transferfolie abgezogen. Das Fixieren des elektrischen Anschlusses an der Platte erfolgt beispielsweise durch ein Anpressen des elektrischen Anschlusses mit dem freigelegten Klebstoffbereich an die Platte.

Nach dem Fixieren des elektrischen Anschlusses kann die Platte Handhabungsprozessen, wie beispielsweise Wenden und/oder Stapeln und/oder Transportieren, unterzogen werden. Hierfür ist es nicht erforderlich, dass der elektrische Leitkleber bereits ausgehärtet ist.

Je nach Typ des elektrischen Leitklebers kann ein Aushärten desselben bei S4 entweder selbsttätig bei Raumtemperatur mit einer gewissen Aushärtezeitdauer (z.B. bei Verwendung eines 2K-Leitkleber) oder erst nach einer wählbaren Zeitdauer durch Energiezufuhr (z.B. einer Wärmeanwendung) erfolgen.

Sofern eine Wärmeanwendung für das Aushärten des elektrischen Leitklebers erforderlich ist, kann diese in einem späteren Prozess z.B. in einem Wärmeofen erfolgen. Es ist auch möglich, hierfür die bei einem Beschichtungsverfahren erforderlich Wärmeanwendung zu nutzen. Beispielsweise kann die bei einer Pulverbeschichtung erforderliche Erhitzung der Platte gleichzeitig für die Aushärtung des Leitklebers verwendet werden.

Offenbart ist ferner ein elektrischer Anschluss, der zur elektrischen Kontaktierung einer Kontaktstelle einer elektrischen Leiterbahn vorgesehen ist, welche über einer Metallplatine verläuft. Der elektrische Anschluss weist ein Metallpad auf, das mittels eines elektrischen Leitklebers elektrisch leitend mit der Kontaktstelle verbindbar ist. Ferner umfasst der elektrische Anschluss ein mit dem Metallpad verbundenes Anschlusselement, welches zur Kopplung des elektrischen Anschlusses an eine externe elektrische Leitung ausgelegt ist, sowie einen Klebstoffbereich, der sich in einem Umfangsrandbereich des Anschlusses befindet und dazu ausgelegt ist, den elektrischen Anschluss an der Platte zu fixieren.

## Patentansprüche

1. Platte mit integrierter elektrischer Funktionalität und an der Platte angebrachter elektrischer Anschluss, wobei die Platte umfasst:
eine Metallplatine,
wenigstens eine Isolationsschicht, die über einer Hauptoberfläche der Metallplatine angeordnet ist, und
eine elektrische Funktionsschicht, die über der Isolationsschicht angeordnet ist und wenigstens eine elektrische Leiterbahn sowie eine Kontaktstelle zur elektrischen Kontaktierung der elektrischen Leiterbahn von dem elektrischen Anschluss aufweist, und wobei der elektrische Anschluss umfasst:
ein Metallpad, das mittels eines elektrischen Leitklebers elektrisch leitend mit der Kontaktstelle verbunden ist,
ein mit dem Metallpad verbundenes Anschlusselement, welches zur Kopplung des elektrischen Anschlusses an eine externe elektrische Leitung ausgelegt ist, und
einen Klebstoffbereich, der sich seitlich benachbart dem elektrischen Leitkleber befindet und den elektrischen Anschluss an der Platte fixiert.

2. Platte und daran angebrachter elektrischer Anschluss nach Anspruch 1, wobei der elektrische Anschluss ferner aufweist:
eine Trägerfolie aus einem isolierenden Material, die das Metallpad trägt und eine Öffnung aufweist, in welcher das Metallpad von dem elektrischen Leitkleber kontaktiert wird, wobei der Klebstoffbereich zwischen der Trägerfolie und der Platte angeordnet ist.

3. Platte und daran angebrachter elektrischer Anschluss nach Anspruch 2, wobei die Trägerfolie zumindest ein Positionierungsmerkmal zur lagerichtigen Anbringung des Metallpads auf die Kontaktstelle aufweist.

4. Platte und daran angebrachter elektrischer Anschluss nach einem der vorhergehenden Ansprüche, wobei der Klebstoffbereich den elektrischen Leitkleber seitlich von allen Seiten umgibt.

5. Platte und daran angebrachter elektrischer Anschluss nach einem der vorhergehenden Ansprüche, wobei der Klebstoff des Klebstoffbereichs ein Haftklebstoff ist.

6. Platte und daran angebrachter elektrischer Anschluss nach einem der vorhergehenden Ansprüche, wobei die Metallplatine eine Platine aus Stahl oder Aluminium oder Magnesium oder Kupfer oder Legierungen basierend auf den genannten Materialien ist.

7. Platte und daran angebrachter elektrischer Anschluss nach einem der vorhergehenden Ansprüche, wobei die elektrische Funktionsschicht eine elektrische Leistungseinrichtung, insbesondere eine Widerstandsheizung und/oder eine Strom-Leistungsverbindung umfasst.

8. Platte und daran angebrachter elektrischer Anschluss nach einem der vorhergehenden Ansprüche, wobei die elektrische Leiterbahn und die Kontaktstelle mittels einer elektrisch leitfähigen Tinte, insbesondere mit einer Silberpartikel und/oder Kupferpartikel enthaltenden Tinte gedruckte Strukturen sind.

9. Platte und daran angebrachter elektrischer Anschluss nach einem der vorhergehenden Ansprüche, ferner aufweisend:
eine über der elektrischen Funktionsschicht und optional über dem Metallpad angeordnete Beschichtung, insbesondere Pulverbeschichtung.

10. Verfahren zum elektrischen Kontaktieren einer Platte mit integrierter elektrischer Funktionalität, welches umfasst:
Bereitstellen der Platte, die eine Metallplatine, wenigstens eine Isolationsschicht, die über einer Hauptoberfläche der Metallplatine angeordnet ist, und eine elektrische Funktionsschicht aufweist, wobei die elektrische Funktionsschicht über der Isolationsschicht angeordnet ist und wenigstens eine elektrische Leiterbahn sowie eine Kontaktstelle zur elektrischen Kontaktierung der elektrischen Leiterbahn von einem elektrischen Anschluss aufweist;
Auftragen eines elektrischen Leitklebers auf die Kontaktstelle;
Fixieren eines elektrischen Anschluss an der Platte über dem elektrischen Leitkleber, wobei der elektrische Anschluss ein Metallpad, das mittels des elektrischen Leitklebers elektrisch leitend mit der Kontaktstelle verbindbar ist, ein mit dem Metallpad verbundenes Anschlusselement, welches zur Kopplung des elektrischen Anschlusses an eine externe elektrische Leitung ausgelegt ist, und einen Klebstoffbereich aufweist, der sich seitlich benachbart dem elektrischen Leitkleber befindet und den elektrischen Anschluss an der Platte fixiert; und
Aushärten des elektrischen Leitklebers.

11. Verfahren nach Anspruch 10, wobei zur Bereitstellung der Platte folgende Prozesse durchgeführt werden:
ein- oder mehrfaches Lackieren eines Metallbands oder Metallblechs zur Erzeugung der wenigstens einen Isolationsschicht;
Schneiden des Metallbands oder Metallblechs in einzelne Platinen; und
Erzeugen der elektrischen Funktionsschicht unter Verwendung eines Druckprozesses, insbesondere Siebdruck, zum Bilden der Leiterbahn und der Kontaktstelle aus einer elektrisch leitfähigen Tinte.

12. Verfahren nach Anspruch 10 oder 11, wobei das Auftragen des elektrischen Leitklebers auf die Kontaktstelle mittels einer Schablone erfolgt.

13. Verfahren nach einem der Ansprüche 10 bis 12, wobei das Fixieren des elektrischen Anschlusses an der Platte umfasst:
Abziehen einer den Klebstoffbereich abdeckenden Transferfolie; und
Anpressen des elektrischen Anschlusses mit dem freigelegten Klebstoffbereich an die Platte.

14. Verfahren nach einem der Ansprüche 10 bis 13, wobei die Platte nach dem Fixieren des elektrischen Anschlusses und vor dem Aushärten des elektrischen Leitklebers Handhabungsprozessen, insbesondere Wenden und/oder Stapeln und/oder Transportieren, unterzogen wird.

15. Verfahren nach einem der Ansprüche 10 bis 14, wobei das Verfahren ferner umfasst:
Beschichten, insbesondere Pulverbeschichten der Platte, wobei, falls das Aushärten des elektrischen Leitklebers eine Anwendung von Wärme umfasst, die Wärmeanwendung beim Beschichten erfolgt.
